# EUROPÄISCHE PATENTSCHRIFT

(11) **EP 4 402 426 B1**
(45) Veröffentlichungstag und Bekanntmachung des Hinweises auf die Patenterteilung: **25.11.2026**
(21) Anmeldenummer: 22790461.2
(22) Anmeldetag: 16.09.2022
(51) Int. Cl.: G01B 11/06, H10P 72/00, H10P 74/20

(54) **VERFAHREN UND VORRICHTUNGEN ZUR OPTISCHEN DICKENMESSUNG**
METHOD AND DEVICES FOR MEASURING OPTICAL THICKNESS
PROCÉDÉ ET DISPOSITIFS DE MESURE OPTIQUE D'ÉPAISSEUR

(30) Priorität: 16.09.2021 DE 102021124048
(43) Veröffentlichungstag der Anmeldung: 24.07.2024
(73) Patentinhaber: Precitec Optronik GmbH, 63263 Neu-Isenburg (DE)
(72) Erfinder: WEISS, Stephan, 63110 Rodgau (DE); NIMTSCH, Philipp, 35398 Gießen (DE); BECK, Tobias, 63150 Heusenstamm (DE); DIETZ, Christoph, 63179 Obertshausen (DE)
(74) Vertreter: Ostertag & Partner Patentanwälte mbB
(86) Internationale Anmeldenummer: PCT/EP2022/075768
(87) Internationale Veröffentlichungsnummer: WO 2023/041707

(56) Entgegenhaltungen:
- US-A1- 2018 172 431
- US-A1- 2020 103 220
- US-A1- 2020 340 801

## Beschreibung

### HINTERGRUND DER ERFINDUNG

### Gebiet der Erfindung

Die Erfindung betrifft eine optische Dickenmessvorrichtung mit einer Lichtquelle, einem Messkopf, einem optischen Spektrometer mit einer optischen Komponente zur spektralen Aufspaltung eines Eingangslichts und einem Detektor sowie einer Auswerteeinrichtung.

### Beschreibung des Standes der Technik

Bei der Herstellung von Wafern für die Halbleiterherstellung muss der Wafer nach dem Schneiden auf die richtige absolute Gesamtdicke und eine erforderliche minimale Dickenverteilung innerhalb des Wafers mittels eines Schleifprozesses gebracht werden. Um den Prozess beim Schleifen zu kontrollieren, wird während des Schleifens die Dicke des Wafers gemessen. Nachdem während des Schleifens die Dicke deutlich abnehmen kann, ist der für den Messprozess abzudeckende Messbereich beträchtlich.

Es sind zum Messen der Dicke eines Wafers Systeme bekannt, die während des Schleifprozesses die Dicke des Wafers spektralinterferometrisch messen. Solche Systeme umfassen im Allgemeinen eine Lichtquelle, einen Messkopf und ein optisches Spektrometer. Der Messkopf richtet das Licht der Lichtquelle auf den zu vermessenden Wafer und empfängt das von dort reflektierte Licht. Das reflektierte Licht wird dem Spektrometer zugeleitet und dort nach seinen Wellenlängenkomponenten aufgespalten. Dies ermöglicht eine Messung des optischen Spektrums des reflektierten Lichtes. Das Messergebnis wird in einer Auswerteeinrichtung ausgewertet und so die Dicke des Wafers bestimmt.

Die Druckschrift US 2020/0103220 A1 beschreibt eine Vorrichtung zur Dickenmessung, welche die Dicke eines Wafers misst. Die Vorrichtung umfasst eine Lichtquelle, die Licht mit einem Transmissionswellenlängenbereich zum Wafer emittiert, eine Fokussiereinheit, die das von der Lichtquelle emittierte Licht auf den auf einem Aufspanntisch gehaltenen Wafer richtet, einen optischen Verzweigungsabschnitt, der das vom auf dem Aufspanntisch gehaltenen Wafer reflektierte Licht verzweigt, ein Beugungsgitter, welches das reflektierte Licht beugt, das durch den optischen Verzweigungsabschnitt verzweigt wird, um gebeugtes Licht unterschiedlicher Wellenlängen zu erhalten, einen Bildsensor, der die Intensität des gebeugten Lichts erfasst, das durch das Beugungsgitter erhalten wird, um eine spektrale Interferenzwellenform zu erzeugen, und eine Recheneinheit, die die durch den Bildsensor erzeugte spektrale Interferenzwellenform berechnet, um Dickeninformationen auszugeben.

Mit den vorhandenen Systemen kann in der Regel nur entweder der anfänglich dicke Wafer oder der nach dem Schleifprozess entstandene dünne Wafer vermessen werden. Dies liegt in erster Linie daran, dass für den Wafer in seiner Ausgangsdicke das Licht der Lichtquelle eine Wellenlänge im Infrarotbereich aufweisen muss. Der Wafer (beispielsweise Silizium) ist im sichtbaren Spektrum weitgehend intransparent bzw. das sichtbare Spektrum besitzt nur eine geringe Eindringtiefe. Gleichzeitig sind Lichtquellen, die Licht in diesem Spektrum emittieren, nicht breitbandig genug, um eine ausreichend gute Präzision bei dünneren Schichten zu ermöglichen, für die Messlicht im sichtbaren Bereich eine deutlich höhere Genauigkeit bietet.

Dies bedingt in der Regel die Verwendung zweier separater Interferometrie-Systeme mit den damit verbundenen höheren Kosten und höherem Aufwand bezüglich Kalibrierung und Synchronisierung der Geräte.

Auch eine teilweise Integration beispielsweise der Auswerteeinheiten oder der Messköpfe löst die oben angesprochenen Probleme nur bedingt, da weiterhin die meisten Komponenten in doppelter Ausführung benötigt werden.

### ZUSAMMENFASSUNG DER ERFINDUNG

Es ist eine Aufgabe der Erfindung, eine optische Dickenmessvorrichtung für die Messung eines großen Schichtdickenbereichs anzugeben, welche die oben genannten Nachteile zumindest lindert und insbesondere einen großen Messbereich abdeckt und gleichzeitig kompakt und kostengünstig im Aufbau ist.

Die Aufgabe wird durch eine optische Dickenmessvorrichtung gemäß dem unabhängigen Anspruch 1 und dem unabhängigen Anspruch 12 gelöst. Weitere Ausgestaltungen der Erfindung sind in den abhängigen Ansprüchen angegeben.

Die erfindungsgemäße optische Dickenmessvorrichtung weist eine Lichtquelle, einen Messkopf sowie ein optisches Spektrometer auf. Das optische Spektrometer weist eine optische Komponente zur spektralen Aufspaltung eines Eingangslichts und einen Detektor auf. Des Weiteren weist die optische Dickenmessvorrichtung eine Auswerteeinrichtung auf. Die Lichtquelle ist mit dem Messkopf optisch verbunden, beispielsweise durch einen Lichtwellenleiter, und dazu eingerichtet, ein zumindest niedrig-kohärentes Messlicht zu erzeugen und dieses an den Messkopf, beispielsweise über den genannten Lichtwellenleiter, zu leiten. Der Begriff "optisch verbunden" soll hier und im Folgenden sowohl eine lichtwellenleiterbasierte Übertragung des Lichts - also beispielsweise über eine Faser - als auch eine freistrahlbasierte Übertragung einschließen.

Der Messkopf ist dazu eingerichtet, das Messlicht auf ein Messobjekt, beispielsweise einen Wafer, zu leiten. Dies kann beispielsweise im Freistrahl durch Luft oder ein entsprechendes Medium wie Wasser, Öl, Säuren oder andere bei der Waferbearbeitung verwendete Flüssigkeiten geschehen. Des Weiteren ist der Messkopf dazu eingerichtet, von dem Messobjekt reflektiertes Licht, das für die Messung von mindestens zwei unterschiedlichen Oberflächen des Messobjekts stammt, aufzufangen und als Eingangslicht an das Spektrometer zu leiten, beispielsweise über einen Lichtwellenleiter. Bei den unterschiedlichen Oberflächen kann es sich beispielsweise um die Vorderseite und die Rückseite des Wafers oder allgemein um verschiedene optische Grenzflächen handeln.

Das Spektrometer ist mit der Auswerteeinrichtung elektrisch verbunden und dazu eingerichtet, ein optisches Spektrum der Interferenz des Reflexionslichts, das von den mindestens zwei unterschiedlichen optischen Grenzflächenstammt, mittels der optischen Komponente zu erzeugen, mittels des Detektors in elektrische Signale umzuwandeln und die elektrischen Signale an die Auswerteeinrichtung zu senden.

Die Auswerteeinrichtung ist dazu eingerichtet, einen Abstand zwischen mindestens zwei Grenzflächen - also beispielsweise die Dicke des Messobjekts oder einer Schicht des Messobjekts - zu bestimmen. Die Bestimmung der Dicke erfolgt über die Auswertung der durch den Lauflängenunterschied zwischen den Grenzflächen bedingten Modulationen der Interferenz, beispielsweise über eine Fouriertransformation. Die so ermittelte optische Dicke wird anhand der bekannten Brechungsindizes des Materials zurückgerechnet auf die geometrische Dicke.

Erfindungsgemäß ist vorgesehen, dass das Messlicht einen ersten und einen zweiten Wellenlängenbereich aufweist und das Spektrometer zwei Lichteingänge für das Reflexionslicht aufweist, wobei durch den ersten Lichteingang Reflexionslicht des ersten Wellenlängenbereichs tritt und durch den zweiten Lichteingang Reflexionslicht des zweiten Wellenlängenbereichs tritt. Die Lichteingänge sind derart räumlich beabstandet, dass beide Wellenlängenbereiche durch eine gemeinsame Komponente spektral aufgespalten werden und die Abbildungsbereiche auf dem Detektor sich in Richtung der spektralen Aufspaltung überlappen.

Die Wellenlängenbereiche sind bevorzugt niedrigkohärent, das heißt es handelt sich um polychromatisches Licht.

Es können neben einem ersten und einem zweiten Wellenlängenbereich auch ein dritter oder mehr Wellenlängenbereiche eingesetzt werden. Entsprechend kann jeweils der für die Ermittlung des Grenzflächenabstands am besten geeignete Wellenlängenbereich verwendet werden.

In einer bevorzugten Ausführungsform der Erfindung ist vorgesehen, zwischen den Wellenlängenbereichen umzuschalten, insbesondere in einem festen Takt hin- und herzuschalten.

Die Umschaltung zwischen den einzelnen Wellenlängenbereichen kann beispielsweise mit einer Umschaltrate im kHz-Bereich, beispielsweise zwischen 0,5 kHz und 100 kHz, erfolgen. Eine solche schnelle Umschaltrate ermöglicht eine quasi-gleichzeitige Messung mit mehreren Wellenlängenbereichen, insbesondere ist eine Änderung des Abstands zwischen den Schichten wie beispielsweise eine Waferdicke zwischen den beiden Messzeitpunkten klein relativ zur Messgenauigkeit.

Bei der gemeinsamen optischen Komponente, welche das Licht spektral aufspaltet, kann es sich beispielsweise um ein dispersives optisches Element handeln. Unter einem dispersiven optischen Element wird ein optisches Element verstanden, bei dem eine für die Funktion im Vordergrund stehende optische Eigenschaft, z.B. die Brechzahl oder ein Beugungswinkel, eine ausgeprägte Dispersion zeigt und die Dispersion für die Funktion gewünscht ist. Eine normale Linse aus Glas stellt somit - obwohl die Brechkraft in geringem Maße wellenlängenabhängig ist - kein dispersives optisches Element dar. Anders ist dies hingegen bei Dispersionsprismen oder Beugungsgittern, die eine starke Dispersion zeigen und dafür ausgelegt sind, Licht unterschiedlicher Wellenlängen unterschiedlich stark zu brechen oder zu beugen.

Bei dem spektralen Aufspalten durch die optische Komponente findet eine Beugung, Reflexion bzw. Brechung in Abhängigkeit von der Wellenlänge derart statt, dass der Auftreffort nach Fokussierung des gebeugten/reflektierten/gebrochenen Lichts von der Wellenlänge abhängt. Umgekehrt kann somit durch die Wahl eines geeigneten Einstrahlortes die Ortsverschiebung durch die beiden unterschiedlichen Wellenlängenbereiche zumindest teilweise ausgeglichen und eine einzige optische Komponente und ein einziger Detektor für zwei unterschiedliche Wellenlängenbereiche genutzt werden.

Bevorzugt ist jedem der Lichteingänge ein Wellenlängenbereich zugeordnet. Dies ermöglicht es - wie bereits erwähnt - den durch die unterschiedlichen Wellenlängenbereiche verursachten unterschiedlichen Beugungs-/Reflexions-/Brechungswinkel zumindest teilweise zu kompensieren und so zumindest eine teilweise Überlappung des spektral aufgespaltenen Strahlengangs zu erzeugen.

Dies ermöglicht einen besonders kompakten Aufbau des Spektrometers, was einerseits Kosten spart und es ermöglicht, besonders strengen Bauraumanforderungen zu entsprechen. Andererseits ist eine solche kompakte Bauweise auch der Genauigkeit des Spektrometers zuträglich: Je kleiner die Abmessungen der optischen Elemente des Spektrometers (beispielsweise die Durchmesser der Linsen) sind, desto einfacher ist es, eine nahezu fehlerfreie Abbildung über den gesamten spektralen Bereich beider Wellenlängenbereich zu erreichen. Je besser die Abbildungsqualität ist, desto höher ist der Modulationskontrast und damit auch die Qualität des Messergebnisses. Das erforderliche Feld der Einkoppel- und Auskoppeloptik wird auf diese Weise möglichst ähnlich und dadurch minimal. Außerdem wird durch die überlappenden Spektren auch die benötigte Detektorlänge minimiert, bzw. die Aufspaltung kann über mehr Detektorpixel erfolgen, wodurch die Auflösung verbessert wird.

Unter dem Begriff Lichteingang soll hier nicht zwingend ein an einem äußeren Gehäuse angebrachter Eingang, sondern der Eintrittsort des jeweiligen Lichts in den Strahlengang des Spektrometers verstanden werden.

Bei einer bevorzugten Ausführungsform umfasst die Lichtquelle mindestens eine erste Lichtquelleneinheit und eine zweite Lichtquelleneinheit.

Bevorzugt wird das durch die beiden Lichtquelleneinheiten erzeugte Messlicht über optische Verbindungen, beispielsweise Lichtwellenleiter, in den Messkopf eingekoppelt. Besonders bevorzugt wird das Messlicht jeder Lichtquelleneinheit über einen eigenen Lichtwellenleiter eingekoppelt. Besonders bevorzugt werden Fasern unterschiedlichen Typs für die beiden Wellenlängenbereiche verwendet. Dabei kann der Fasertyp hinsichtlich seiner Übertragungseigenschaften auf den Wellenlängenbereich abgestimmt sein, beispielsweise kann es sich um Singlemode- oder Multimode-Fasern handeln. Die beiden Lichtwellenleiter können in einen gemeinsamen Mantel gehüllt sein. Alternativ wird das Messlicht beider Lichtquelleneinheiten über einen gemeinsamen Lichtwellenleiter eingekoppelt.

Alternativ kann auch vorgesehen sein, dass für jeden Wellenlängenbereich ein separater Messkopf vorgesehen ist, wobei jeder Messkopf separat mit je einer Lichtquelleneinheit, beispielsweise über je einen Lichtwellenleiter, verbunden ist.

Unabhängig von der Ausgestaltung als separate Lichtquelleneinheiten können die Wellenlängenbereiche im sichtbaren und Nah-Infrarotbereich (VIS und NIR) liegen, insbesondere zwischen 400 nm und 1600 nm. Beispielsweise kann der erste Wellenlängenbereich zwischen 430 nm und 700 nm liegen. Der zweite Wellenlängenbereich kann beispielsweise ein Teilbereich im Bereich 700 nm bis 1600 nm sein, insbesondere ca. 830 nm bis ca. 930 nm, ca. 870 nm bis ca. 970 nm oder ca. 950 nm bis ca. 1100 nm.

Der mit den Wellenlängenbereichen zu ermittelnde Abstand kann beispielsweise im VIS-Bereich (sichtbaren Bereich) zwischen 0,5 µm und 10 µm liegen, im NIR-Bereich kann er beispielsweise bis zu einer Dicke von 150 µm Silizium betragen.

Bevorzugt unterscheidet sich die Bandbreite der ersten Lichtquelleneinheit von der Bandbreite der zweiten Lichtquelleneinheit. Insbesondere ist der erste Wellenlängenbereich breitbandig und der zweite Wellenlängenbereich vergleichsweise schmaler. Der schmalbandigere Wellenlängenbereich ermöglicht eine Messung von dickeren Wafern,, der breitbandige Wellenlängenbereich liefert eine bessere Genauigkeit für dünne Wafer.

Bei einer bevorzugten Ausführungsform ist die erste Lichtquelleneinheit eine Leuchtdiode (LED) und die zweite Lichtquelleneinheit eine Superlumineszenzdiode (SLD).

Besonders bevorzugt ist der schmalbandigere Wellenlängenbereich für den langwelligen Wellenlängenbereich und der breitbandige Wellenlängenbereich für den kurzwelligen Wellenlängenbereich.

Alternativ zur Verwendung zweier getrennter Leuchtmittel als Lichtquelleneinheiten kann es auch vorgesehen sein, ein einzelnes Leuchtmittel zu verwenden, dessen Spektralbereich beide Wellenlängenbereiche umfasst, und durch Filter oder dichroitische Strahlteiler die Wellenlängenbereiche zu trennen.

Bei einer Ausführungsform kann vorgesehen sein, dass die Lichtquelle so eingerichtet ist, dass das Messlicht im ersten Wellenlängenbereich abwechselnd mit dem Messlicht im zweiten Wellenlängenbereich erzeugbar ist. Auf diese Weise kann schnell zwischen den beiden Messbereichen umgeschaltet werden. Entsprechend kann das Auslesen des Spektrometers bzw. die Auswertung des elektrischen Signals durch die Auswerteeinrichtung synchron dazu stattfinden, beispielsweise in einem festen Takt.

Bei vorteilhafter Ausführungsform ist vorgesehen, dass die erste Lichtquelleneinheit unabhängig von der zweiten Lichtquelleneinheit schaltbar ist.

Dabei ist es auch denkbar, in einem ersten Zeitraum den ersten Wellenlängenbereich, in einem zweiten Zeitraum den ersten und den zweiten Wellenlängenbereich abwechselnd und in einem dritten Zeitraum den zweiten Wellenlängenbereich zu verwenden. Dies bietet die Möglichkeit, dass bei einer Messung einer Dicke, die bereits optimal durch einen Wellenlängenbereich abgedeckt wird, auch nur der entsprechende Wellenlängenbereich emittiert wird.

In einem Messbereich, der von beiden Wellenlängenbereichen ähnlich abgedeckt wird, kann die Emission der beiden Wellenlängenbereiche und die zugehörige Auswertung abwechselnd getaktet erfolgen. Dies bietet die Möglichkeit, die sich so ergebenden Dickenwerte miteinander, beispielsweise gewichtet, zu einem Wert zu verrechnen und so gegebenenfalls eine höhere Messgenauigkeit als nur mit einem einzigen Wellenlängenbereich zu erreichen.

Werden bei einer Messung zwei Spektren für einen Dickenwert erzeugt, kann der Dickenwert aus den beiden Teilspektren errechnet werden. Werden zwei Messspektren mit unterschiedlicher Bandbreite eingesetzt, liefert das schmalbandigere Spektrum für dickere Wafer eine höhere Genauigkeit, das breitbandigere Spektrum für dünne Wafer.

Die Berechnung des Dickenwertes kann beispielsweise eine statistische Gewichtung der beiden Teilspektren vorsehen. Das schmalbandigere Spektrum liefert für dicke Wafer eine höhere Genauigkeit, das breitbandige Spektrum für dünne Wafer. Der errechenbare Dickenwert wird jeweils auf Basis desjenigen Teilspektrums vorgenommen, das sich für die aktuelle Dicke am besten eignet.

Bevorzugt wird bei dieser Berechnung kein fester Schwellenwert, sondern eine Verrechnung beispielsweise anhand eines gewichteten Mittelwerts vorgenommen. Dabei kann ein Übergangsbereich festgelegt sein, innerhalb dessen die Gewichtung davon abhängt, an welcher Stelle des Übergangsbereichs sich die momentan zu messende Dicke ungefähr befindet oder/und die Gewichtung kann vom letzten berechneten Wert oder/und von den beiden gemessenen Werten abhängig sein.

Alternativ oder zusätzlich kann die Gewichtung der beiden Messwerte für die gleiche Dicke auch anhand der Qualität der einzelnen ermittelten Messwerte vorgenommen werden. Als Maß der Qualität kann eine Höhe des Messpeaks (entspricht der Amplitude der Interferenzmodulation) oder ein beliebiges Maß für das statistische Rauschen des Wertes (bspw. Variation über eine Zeitspanne) verwendet werden.

Die Aufgabe wird auch durch ein Verfahren gemäß dem unabhängigen Verfahrensanspruch gelöst.

Das erfindungsgemäße Verfahren dient zur Ermittlung des Abstands zweier Grenzflächen eines Messobjekts und weist die Schritte auf:
Erzeugen eines Messlichts mit einem ersten Wellenlängenbereich; Leiten des Messlichts auf das Messobjekt; Auffangen des von dem Messobjekt reflektierten Lichts und Erzeugen eines Spektrums des Reflexionslichts mit Interferenzmodulationen; Wiederholen der genannten Schritte mit Messlicht eines zweiten Wellenlängenbereichs, wobei sich erster und zweiter Wellenlängenbereich zumindest teilweise unterscheiden; Ermitteln eines ersten Grenzflächenabstandswerts mittels des Spektrums des ersten Wellenlängenbereichs des Messlichts; Ermitteln eines zweiten Grenzflächenabstandswerts mittels des Spektrums des zweiten Wellenlängenbereichs des Messlichts; Berechnen eines Grenzflächenabstands unter Verwendung des ersten und/oder des zweiten Grenzflächenabstandswertes. Die Grenzflächenabstandswerte sind dabei Messwerte für den Abstand zwischen zwei optischen Grenzflächen, insbesondere für die Dicke der Schicht zwischen zwei optischen Grenzflächen. Die Auswertung des ersten und zweiten Wellenlängenbereichs kann nacheinander, abwechselnd oder gleichzeitig erfolgen.

Auf diese Weise kann der Abstand zweier Grenzflächen eines Messobjekts über einen weiten Bereich mit hoher Genauigkeit kontinuierlich gemessen werden. Dabei kann auch in solchen Abstandsbereichen eine hohe Genauigkeit erzielt werden, in denen zwar die Intensität oder Qualität einer der oder beider emittierenden Lichtquelle geringer ist, aber das Messergebnis beider Messlichtbereiche verwendet werden kann.

Bei einer bevorzugten Ausgestaltung des Verfahrens erfolgt die Interferenz des Reflexionslichts entweder zwischen einem Reflexionslicht einer Grenzfläche des Messobjekts und einem Referenzlicht und/oder zwischen einem Reflexionslicht einer ersten Grenzfläche des Messobjekts und dem Reflexionslicht einer zweiten Grenzfläche des Messobjekts. Bei einer Interferenz zwischen Reflexionslicht einer Grenzfläche und Referenzlicht, welches eine bekannte, bzw. zumindest zeitlich konstante Weglänge zurückgelegt hat, kann ein absoluter Abstandswert berechnet werden. Bei einer Interferenz zwischen dem Reflexionslicht zweier Grenzflächen kann ein Abstandswert zwischen den beiden Grenzflächen berechnet werden.

Es ist von Vorteil, wenn bei der Berechnung des Grenzflächenabstands eine Mittelung des ersten und des zweiten Grenzflächenabstands, bevorzugt eine gewichtete Mittelung, erfolgt.

### KURZE BESCHREIBUNG DER ZEICHNUNGEN

Nachfolgend werden Ausführungsbeispiele der Erfindung anhand der Zeichnungen näher erläutert. In diesen zeigen:
- Figur 1: eine schematische Darstellung einer Vorrichtung zur Messung von Dicken gemäß dem Stand der Technik;
- Figur 2: eine erste Ausführungsform einer optischen Dickenmessvorrichtung;
- Figuren 3, 4: verschiedene Betriebszustände der optischen Dickenmessvorrichtung gemäß Figur 2;
- Figur 5: eine zweite Ausführungsform einer optischen Dickenmessvorrichtung mit einem gemeinsamen Messspot;.
- Figur 6: eine dritte Ausführungsform einer optischen Dickenmessvorrichtung mit einer ausschließlich faserbasierten Lichtführung;
- Figur 7: eine vierte Ausführungsform einer optischen Dickenmessvorrichtung mit einem zweizeiligen Detektor;
- Figur 8: eine fünfte Ausführungsform einer optischen Dickenmessvorrichtung mit einem Referenzarm; und
- Figur 9: eine Ausführungsform eines erfindungsgemäßen Verfahrens.

### BESCHREIBUNG BEVORZUGTER AUSFÜHRUNGSBEISPIELE

### Messprinzip und Problemstellung

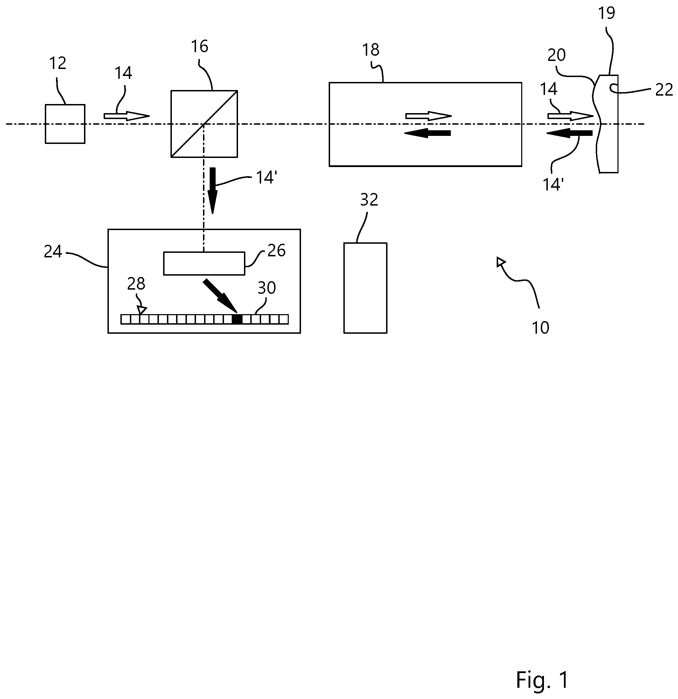

Die Fig. 1 veranschaulicht in einer schematischen Darstellung eine Messvorrichtung 10 gemäß dem Stand der Technik. Eine Messlichtquelle 12 erzeugt Messlicht 14, das über eine Lichtteileinrichtung 16 - beispielsweise einen Strahlteilerwürfel oder einen Faserkoppler - und über einen Messkopf 18 auf ein Messobjekt 19 gerichtet wird. In der Figur 1 ist der Teil des Messlichts 14, der von einer ersten Grenzfläche 20 oder einer zweiten Grenzfläche 22 des Messobjekts 19 reflektiert wird, mit schwarzen Pfeilen angedeutet und mit der Bezugsziffer 14' versehen. Das reflektierte Messlicht 14' wird vom Messkopf 18 aufgenommen und von der Lichtteileinrichtung 16 auf ein Spektrometer 24 gerichtet. Das Spektrometer 24 enthält ein dispersives optisches Element 26, bei dem es sich zum Beispiel um ein Beugungsgitter oder um ein Dispersionsprisma handeln kann.

Ferner enthält das Spektrometer 24 einen Detektor 28, der eine Vielzahl von lichtempfindlichen Zellen 30 umfasst. Die lichtempfindlichen Zellen 30 sind entlang einer geraden oder gekrümmten Linie angeordnet und werden im Folgenden als Pixel bezeichnet. Die von den Pixeln erzeugten Signale werden von einer Auswerteeinrichtung 32 ausgewertet, um daraus einen Abstandswert zwischen den beiden Oberflächen 20, 22 zu berechnen.

Bei einer Messung wird das reflektierte Messlicht 14' durch das dispersive optische Element 26 abgelenkt, wobei der Ablenkwinkel von der Wellenlänge des reflektierten Messlichts 14' abhängt. Bei Messvorrichtungen, bei denen das reflektierte Messlicht 14' der einen Grenzfläche 20 mit Messlicht interferiert, das von einer weiteren Grenzfläche 22 reflektiert wurde, erhält man auf dem Detektor 28 ein breites Spektrum, das spektral moduliert ist. Der Detektor 28 erfasst dann eine Vielzahl von Intensitätsmaxima, wobei jedem Abstand zwischen erster und zweiter Grenzfläche 20, 22 eine Modulationsfrequenz zugeordnet ist. Durch eine Fourier-Transformation lässt sich aus dem vom Detektor 28 erzeugten Signal der gewünschte Abstandswert berechnen, wie dies an sich im Stand der Technik bekannt ist.

### Erstes Ausführungsbeispiel

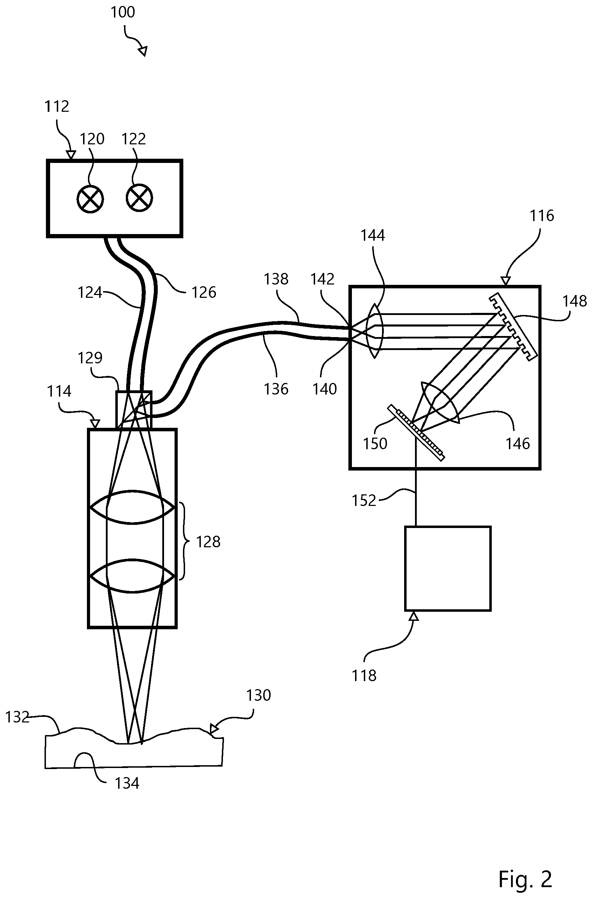

Figur 2 veranschaulicht in einer schematischen Darstellung eine erste Ausführungsform einer optischen Dickenmessvorrichtung 100. Die Dickenmessvorrichtung 100 weist eine Lichtquelle 112, einen Messkopf 114, ein optisches Spektrometer 116 und eine Auswerteeinrichtung 118 auf.

Die Lichtquelle 112 ist dazu eingerichtet, niedrig-kohärentes Licht in mindestens zwei unterschiedlichen Wellenlängenbereichen bzw. Frequenzbändern zu erzeugen. Zumindest einer der beiden Wellenlängenbereiche ist dabei vorteilhafterweise breitbandig, d.h. das ausgesandte Licht umfasst einen ganzen kontinuierlichen Bereich von Wellenlängen, beispielsweise einen Bereich von 100 nm oder mehr. Um dieses Licht zu erzeugen, umfasst die Lichtquelle 112 bei der in Figur 2 dargestellten Ausführungsform zwei Lichtquelleneinheiten 120, 122. Bei dem gezeigten Ausführungsbeispiel ist die eine Lichtquelleneinheit 120 mit einer Leuchtdiode als Strahlungsquelle, die andere Lichtquelleneinheit 122 mit einer Superlumineszenz-(SLD)-Diode als Strahlungsquelle ausgestattet. Beispielhafte Wellenlängenbereiche sind 430 nm-700 nm, 830 nm-930 nm, 870 nm-970 nm oder 950 nm-1100 nm.

Das von den Lichtquelleneinheiten 120, 122 emittierte Licht wird über zwei separate Wellenleiter - in Figur 2 die erste Lichtfaser 124 und die zweite Lichtfaser 126 zum Messkopf 114 geleitet. Das in den Messkopf 114 eingekoppelte Messlicht wird über eine geeignete Optik 128 auf die Oberfläche eines Messobjekts 130 geleitet. Dabei wird Licht je eines Wellenlängenbereichs beziehungsweise je einer Lichtquelleneinheit in je einer der Fasern geleitet. Die Wellenlängenbereiche werden also durch separate Fasern geleitet.

Dabei wird ein Teil des Messlichts an einer ersten Oberfläche 132, ein zweiter Teil an einer zweiten Oberfläche 134 des Messobjekts 130 reflektiert. Der Reflexionsvorgang ist in der Figur 2 lediglich beispielhaft an der ersten Oberfläche 132 dargestellt, um die Darstellung übersichtlich zu halten. Dabei entsteht für jeden Wellenlängenbereich, der in einer separaten Faser geführt wird, ein separater Messspot auf der Oberfläche des Messobjekts 130.

Ein Teil des Lichts, das von den beiden Oberflächen 132, 134 reflektiert wurde, wird wiederum in den Messkopf 114 eingekoppelt, dort in eine der Fasern 136, 138 eingekoppelt und gelangt so zu dem Spektrometer 116.

Messlicht, welches aus der ersten Faser 124 stammt und von einer der Oberflächen 132, 134 des Messobjektes 130 reflektiert wurde, wird dabei von der Optik 128 wieder am Faserende der ersten Faser 124 abgebildet. Vorteilhafterweise umfasst der Messkopf 114 einen Strahlteilerwürfel 129, so dass das vom Messobjekt 130 reflektierte, zurückkehrende Licht zumindest teilweise abgelenkt und auf das Ende einer weiteren Faser 136, welches konjugiert zum Ende der ersten Faser 124 angeordnet ist, abgebildet wird. Somit wird dieses Licht nur in die Faser 136 eingekoppelt. Entsprechend verhält es sich mit dem Messlicht, welches aus der zweiten Faser 126 stammt und vom Messobjekt 130 reflektiert wurde - es wird in eine Faser 138 eingekoppelt, deren Ende konjugiert zum Ende der zweiten Faser 126 angeordnet ist.

Da die Fasern 124, 126 verschiedene Wellenlängenbereiche transportieren, sind auch die Wellenlängenbereiche, welche in die Fasern 136, 138 eingekoppelt werden, unterschiedlich, ohne dass eine zusätzliche Filterung oder Schaltung notwendig wäre. Die Lichtwellenleiter 136, 138 sind so mit dem Spektrometer 116 verbunden, dass zwei räumlich voneinander beabstandete Lichteingänge 140, 142 für die Fasern 136, 138 vorgesehen sind. Bei einer konkreten Ausführungsform können die Lichteingänge beispielsweise 1-30 mm, bevorzugt 15 mm, beabstandet sein. Im Spektrometer 116 durchläuft das über die beiden Lichteingänge 140, 142 in das Spektrometer 116 eingekoppelte Reflexionslicht dieselbe Spektrometeroptik, hier angedeutet durch Optiken 144, 146 sowie beispielhaft einem Reflexionsgitter 148.

Anstatt eines Reflexionsgitters 148 kann auch ein in Transmission arbeitendes Gitter oder ein Prisma vorgesehen sein.

Das Reflexionsgitter 148 spaltet das Reflexionslicht spektral auf. Das Ergebnis der spektralen Aufspaltung wird auf einen Detektor 150 abgebildet. Der Detektor 150 ermöglicht eine ortsabhängige Erfassung einer Intensitätsverteilung und kann beispielsweise zeilenförmig, beispielsweise mit den Zellen bzw. Pixel wie einleitend beschrieben ausgebildet sein.

In einer beispielhaften, aus Gründen der Übersichtlichkeit nicht dargestellten Ausführungsform kann das Reflexionsgitter so angeordnet sein, dass die Abbildung der Lichteingänge auf das Gitter und die Abbildung vom Gitter auf den Detektor durch dieselbe Optik geschieht, d.h. die Optiken 144 und 146 fallen zusammen.

Der Detektor 150 erfasst die Intensität des Messlichts in Abhängigkeit von dem Ort und damit aufgrund der Aufspaltung durch die optische Komponente wie beispielsweise das Reflexionsgitter 148 in Abhängigkeit von der Wellenlänge. Das Licht aus den beiden unterschiedlichen Lichtwellenleitern 136, 138 durchläuft wie erwähnt dieselbe Optik des Spektrometers 116. Die Lichtquellen 120, 122 werden abwechselnd ein- und ausgeschaltet, sodass immer nur Licht aus einem einzigen Wellenlängenbereich auf der aktiven Fläche des Detektors 150 landet. Der Detektor 150 kann synchron zum Ein-/Ausschalten der Lichtquellen 120, 122 ausgelesen werden, sodass das so erfasste Spektrum eindeutig einer Lichtquelle 120, 122 zugeordnet werden kann.

Der Detektor 150 bzw. dessen Detektorzeile erzeugt aus dem optischen Spektrum ein entsprechendes Signal, das über die Auswerteeinrichtung 118 ausgelesen wird. Die Auswerteeinrichtung 118 ist mit dem Detektor 150 über eine elektrische Verbindung 152 verbunden.

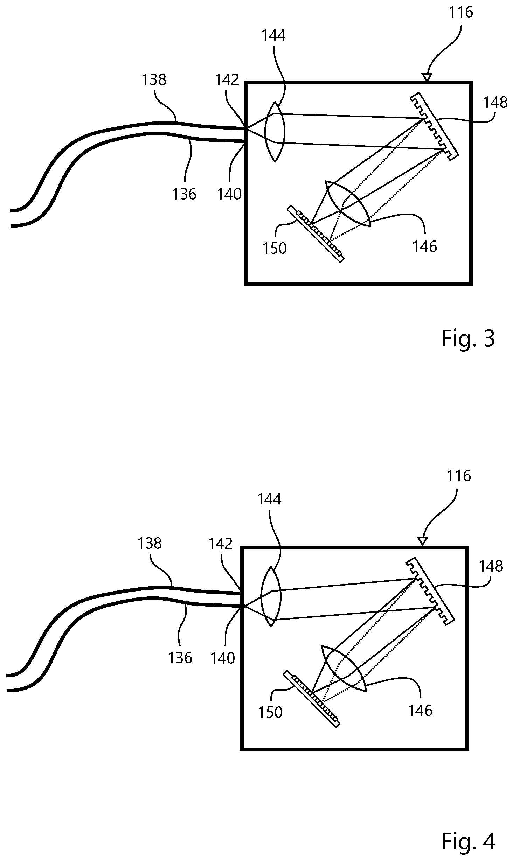

Die Figuren 3 und 4 zeigen in einer schematischen Darstellung einen Ausschnitt aus der Figur 2 zur Veranschaulichung verschiedener Betriebszustände. In Figur 3 wird Reflexionslicht über den Wellenleiter 138 an den Lichteingang 142 geleitet, das einem ersten Wellenlängenbereich - hier beispielsweise 430 nm - 700 nm - zugeordnet ist. Ausgehend von dem Eingangsort 142 wird das Reflexionslicht über die erste Optik 144 kollimiert und auf das Reflexionsgitter 148 gelenkt. Von dort gelangt es spektral aufgespaltet, d.h. mit einem von der Wellenlänge abhängigen Reflexionswinkel auf die zweite Optik 146 und wird dort auf eine Zeile des Detektors 150 abgebildet. Wie in der Figur 3 angedeutet ergeben sich auf dem Detektor 150 örtlich unterschiedliche Intensitäten in Abhängigkeit von der Wellenlänge des Reflexionslichts. Gezeigt ist der Strahlengang (schematisch) für zwei verschiedene Wellenlängen des ersten Wellenlängenbereichs, wobei die größere Wellenlänge gestrichelt gezeichnet ist. Das auf den Detektor 150 fallende Licht bedeckt einen bestimmten Bereich der aktiven Fläche des Detektors 150. Es zeigt sich somit auf der Detektorzeile 150 ein örtlich aufgelöstes Spektrum des Reflexionslichts.

Wird hingegen, wie in Figur 4 veranschaulicht, Licht in einem zweiten Wellenlängenbereich - hier beispielsweise 830 nm - 930 nm - über die Faser 136 an den Lichteingang 140 herangeleitet, koppelt dieses Reflexionslicht ebenfalls in die Optik 144 ein und wird von dort kollimiert auf das Reflexionsgitter 148 abgebildet. Aufgrund des anderen Abstrahlortes des Lichteingangs 140, der zu dem des Lichteingangs 142 beabstandet ist, ergibt sich ein anderer Einstrahlwinkel auf das Reflexionsgitter 148. Dieser Einstrahlwinkel auf das Reflexionsgitter 148 ist so gewählt, dass er den durch den anderen Wellenlängenbereich des Reflexionslichts bedingten anderen Ausfallswinkel für das von dem Gitter 148 spektral aufgespaltete Licht kompensiert und der Detektor 150 wiederum über die Optik 146 eine Intensitätsverteilung über den Ort der Detektorzeile in Abhängigkeit von der Wellenlängenverteilung des Reflexionslichts darstellen kann.

In Figur 4 wird Licht aus dem Bereich 830 nm - 930 nm über einen zweiten Eingang 140 in das Spektrometer 116 eingekoppelt. Aufgrund der größeren Wellenlänge wird das Licht vom optischen Gitter 148 stärker gebeugt als das Licht des Bereichs 430 nm-700 nm. Um diesen Effekt auszugleichen, ist der zweite Eingang 140 gegenüber dem ersten Eingang 142 lateral versetzt, sodass das Reflexionslicht unter einem steileren Winkel auf das optische Gitter 148 auftrifft. Durch die geeignete Wahl des lateralen Versatzes lässt sich erreichen, dass sich die Bereiche auf der aktiven Fläche des Detektors 150, auf denen das Licht aus dem jeweiligen Spektrum landet, zumindest teilweise überlappen. Dies ermöglicht eine besonders kompakte Bauweise.

### Zweites Ausführungsbeispiel

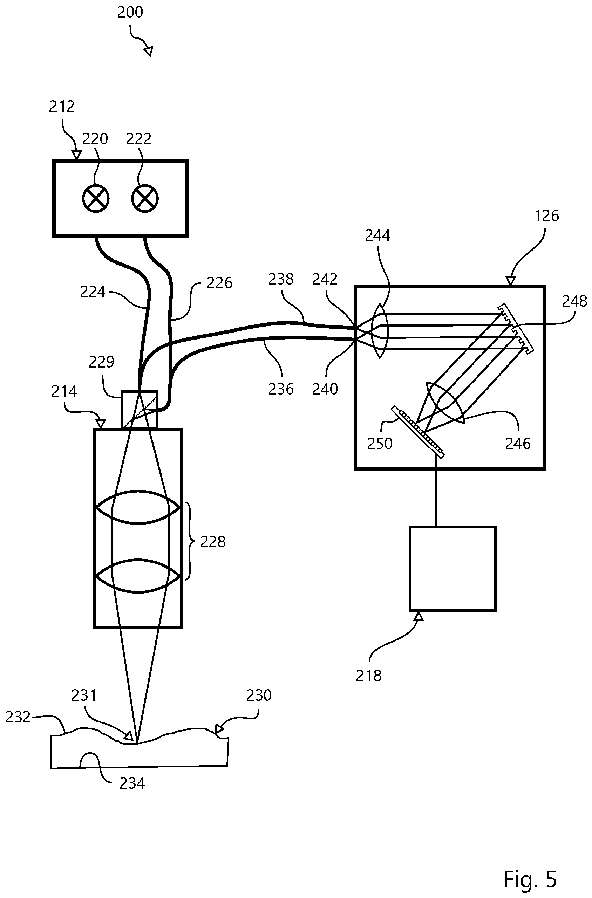

Die Figur 5 veranschaulicht eine alternative Ausführungsform einer erfinderischen Dickenmessvorrichtung 200. Für alle Merkmale, die nachfolgend beschrieben werden, werden unter Bezugnahme auf die Bezugszeichen der Figur 2 die gleichen Bezugszeichen, nur mit 100 addiert, verwendet. Diese werden, soweit nicht erforderlich, nicht erneut beschrieben.

Die optische Dickenmessvorrichtung 200 umfasst eine Lichtquelle 212, die zwei Lichtquelleneinheiten 220, 222 aufweist. Im Unterschied zu der Ausführungsform der Figur 2 werden die verschiedenen Wellenlängenbereiche der Lichtquelle 212 über den Messkopf 214 auf einen gemeinsamen Messspot 231 zugeleitet.

Das aus den Lichtquelleneinheiten 220, 222 austretende Licht wird über zwei Fasern 224, 226 einem dichroitischen Strahlteiler 229 zugeleitet. Das Licht eines ersten Wellenlängenbereichs einer Lichtquelleneinheit 220, das aus einer ersten Faser 224 in den Strahlteiler 229 eintritt, wird transmittiert, trifft auf das Messobjekt 230 (bzw. auf eine der beiden Grenzflächen 232, 234), wird von dort reflektiert und tritt wieder in die Faser 224 ein. Eine Faser 238 ist über einen Faserkoppler mit der Faser 224 verbunden. Über diesen Faserkoppler wird dieses reflektierte Licht in die Faser 238 geleitet, welche das Licht zu dem Lichteingang 242 führt. Analog geht das Licht des anderen Wellenlängenbereichs der Lichtquelleneinheit 222 in eine zweite Faser 226, tritt in der gezeigten Ausführungsform seitlich in den Strahlteiler 229 ein, wird dort in Richtung Messkopf/Messobjekt reflektiert und gelangt nach der Reflexion an dem Messobjekt 230 wieder in die Faser 226 und wird von dort über einen Faserkoppler zu dem Spektrometer 226 bzw. dem zugehörigen Lichteingang 240 geleitet. Der dichroitische Strahlteiler 238 ist so gewählt, dass Licht des Wellenlängenbereiches, der über die Faser 224 zugeleitet wird, möglichst vollständig transmittiert wird, während Licht des Wellenlängenbereiches, das über die Faser 226 zugeleitet wird, möglichst vollständig reflektiert wird.

Alternativ zu dieser Ausführungsform kann der Strahlteiler 229 nicht direkt mit dem Messkopf 214 verbunden sein, sondern als separates Element vorliegen. In diesem Fall kann man das Messlicht der Lichtquelle 212 über eine einzelne Faser in den Messkopf 214 führen und erst kurz vor dem Spektrometer trennen.

### Drittes Ausführungsbeispiel

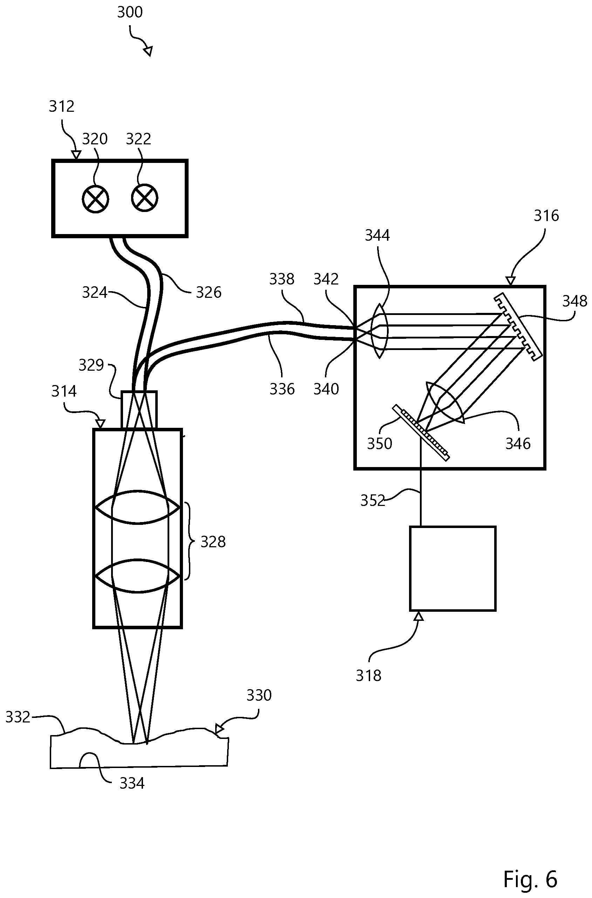

Figur 6 veranschaulicht eine weitere Ausführungsform einer Dickenmessvorrichtung 300. Im Unterschied zu den vorhergehend beschriebenen Ausführungsformen der Figuren 2 und 5 ist die Lichtführung in dieser Ausführungsform außerhalb von Messkopf 314 und Spektrometer 316 vollständig faserbasiert. Wie im Ausführungsbeispiel der Figur 2 werden die verschiedenen Wellenlängenbereiche durch separate Fasern 324, 326 an unterschiedlichen Orten in den Messkopf eingekoppelt, und rückkehrendes Licht wird dementsprechend auch wieder am Ende der entsprechenden Faser abgebildet und nur dort eingekoppelt. Über Faserkoppler wird rückkehrendes Licht in den Fasern 324 und 326 in die Fasern 338 bzw. 336 und von dort zum Spektrometer geleitet.

Das dritte Ausführungsbeispiel entspricht weitgehend dem ersten Ausführungsbeispiel, wobei der Strahlteiler durch Faserkoppler ersetzt wurde.

Umgekehrt wäre es auch möglich, die Strahlführung vollständig im Freistrahl auszuführen.

Bei allen vorgenannten Ausführungsformen kann vorgesehen sein, dass die räumlich getrennte Einkopplung in das Spektrometer 116, 216, 316 über Ferrulen erfolgt, die getrennt nebeneinander angeordnet sein können. Alternativ kann die Einkopplung auch über eine Doppelferrule erfolgen. Anhand der Position der Ferrulen oder des Abstands der Fasern in der Doppelferrule kann die Position der Teilspektren in der Detektorebene eingestellt werden.

Die Trennung der Teilspektren auf dem Detektor kann einerseits wie bereits beschrieben so eingestellt werden, dass für beide Wellenlängenbereiche eine weitgehende räumliche Überlappung auf dem Detektor vorliegt und die Trennung durch eine zeitliche Taktung der Lichtquelle bzw. der Lichtquelleneinheiten erzielt wird.

Alternativ kann auch eine räumliche Trennung der Teilspektren auf dem Detektor in der Form erzielt werden, dass die räumliche Beabstandung der Eingänge am Spektrometer so gewählt wird, dass die Teilspektren des vom Gitter aufgespaltenen Reflexionslichts auf zwei verschiedenen Detektorzeilen zu liegen kommen. Auf diese Weise kann eine zeitliche Taktung entfallen.

Die Beabstandung der Eingangsstellen am Spektrometer kann auch so gewählt bzw. kombiniert werden, dass die Detektorzeilen direkt übereinander liegen und so eine besonders kompakte Anordnung erreicht werden kann.

In einer weiteren Alternative kann die räumliche Beabstandung der Eingänge am Spektrometer so geartet sein, dass die Spektren sich auf dem Detektor nicht überlappen. In diesem Fall kann synchron zum Schalten der Lichtquellen nur ein Teilbereich des Detektors ausgelesen werden, um die Ausleserate zu erhöhen. Beispielsweise können die Spektren auf einem zeilenförmig ausgestalteten Detektor nebeneinander in der Zeile zu liegen kommen. Dabei kann der eigentlich aufgrund der Beugungs-/Brechungs-/Reflektionsbedingungen vorbestimmte Abstand der Spektren durch die räumlich Anordnung und Ausrichtung der Lichteingänge reduziert werden, so dass eine optimierte Ausnützung der vorhandenen Detektorfläche erfolgen kann.

### Viertes Ausführungsbeispiel

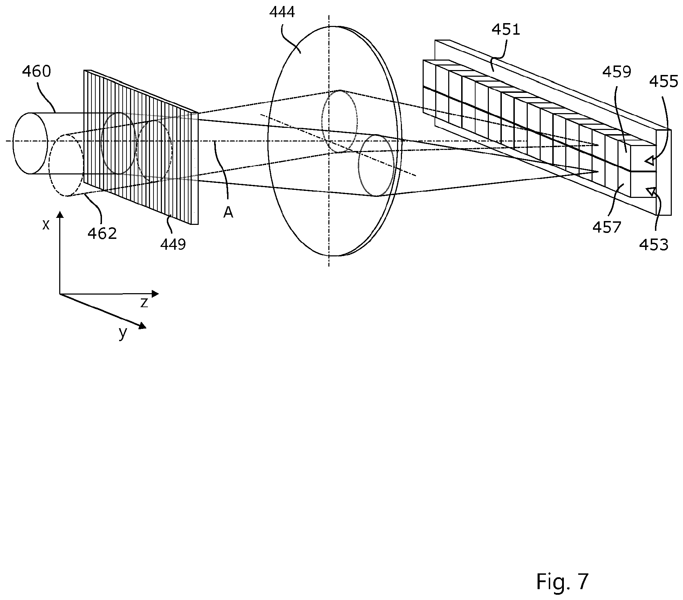

Dies ist in der Figur 7 veranschaulicht. Die Figur 7 zeigt schematisch einen Teil des Spektrometers 116. Erkennbar ist ein dispersives optisches Element, das hier vor allem aus Gründen der besseren Darstellbarkeit als Transmissionsgitter 449 ausgebildet ist. Das Transmissionsgitter 449 ist im kollimierten Strahlengang angeordnet, wie dies auch bei den in den Figuren 2, 5 und 6 gezeigten Reflexionsgittern 148, 248, 348 der Fall ist. Wie auch bei den anderen Ausführungsbeispielen, fokussiert die Sammellinse 444 das gebeugte Licht auf den Detektor 451.

Im Unterschied zu den vorstehend beschriebenen Ausführungsbeispielen weist der Detektor 451 nicht nur eine, sondern zwei Pixelzeilen 453, 455 auf. Entlang der ersten Pixelzeile 453, durch die hindurch im dargestellten Ausführungsbeispiel die Achse A verläuft, sind erste Pixel 457 angeordnet, die ausschließlich für Licht eines ersten Wellenlängenbereichs gedacht sind. Entlang der zweiten Pixelzeile 455, die entlang der x-Richtung versetzt, aber parallel zur ersten Pixelzeile 453 verläuft, sind zweite Pixel 459 angeordnet, die ausschließlich für Licht eines zweiten Wellenlängenbereichs gedacht sind. Durch die Aufteilung auf zwei Pixelzeilen kann die Umschaltung der Lichtquellen entfallen.

Das Licht eines ersten Wellenlängenbereichs - in der Figur 7 als Strahlbündel 460 mit durchgezogenen Linien dargestellt - fällt entlang der Achse A auf das dispersive optische Element (Transmissionsgitter 449). Die Achse A ist beispielsgemäß um einen ersten Winkel α gegenüber der z-Achse verkippt. Da die beugenden Strukturen des Transmissionsgitters 449 sich entlang der x-Richtung erstrecken, wird das Licht 460 wellenlängenabhängig in der durch die Achse A und die y-Achse aufgespannten Ebene abgelenkt und von der Sammellinse 444 auf einen der ersten Pixel 457 der ersten Pixelzeile 453 gerichtet.

Das kollimierte Strahlbündel 462 - in der Figur 7 gestrichelt angedeutet - ist Licht eines zweiten Wellenlängenbereichs und trifft bei diesem Ausführungsbeispiel entlang einer zur Achse A verkippten zweiten Achse auf das Transmissionsgitter 449. Dadurch fokussiert die Sammellinse 444 das in der yz-Ebene gebeugte Licht nicht auf einem Pixel 457 der ersten Pixelzeile 453, sondern auf einem der zweiten Pixel 459 der in x-Richtung versetzt dazu angeordneten zweiten Pixelzeile 455. Infolge der unterschiedlichen Einfallsrichtungen können das Licht 460 des ersten Wellenlängenbereichs und das Licht 462 des zweiten Wellenlängenbereichs somit nicht auf den gleichen Pixel fokussiert werden.

Gleichzeitig ist die Einstrahlrichtung zumindest eines der beiden Strahlbündel 460, 462 bezüglich der z-Achse so gewählt, dass zumindest teilweise eine Kompensation der wellenlängenabhängigen Beugung stattfindet und somit Licht eines anderen Wellenlängenbereichs durch das gleiche dispersive Element so abgelenkt wird, dass es auch auf dem Detektor 451 landet. Konkret ist in diesem Ausführungsbeispiel die Einstrahlrichtung des Lichtbündels 462 so gewählt, dass die Einfallsrichtung auf das dispersive Element 449 einen Winkel mit der xz-Ebene einschließt. Dieser Winkel ist so gewählt, dass die durch den anderen Wellenlängenbereich bedingt stärkere oder schwächere Ablenkung in der yz-Ebene "korrigiert" wird. Das dispergierte Licht trifft somit ebenfalls auf den Detektor 451 auf, aber eben wie vorstehend beschrieben auf der zweiten Detektorzeile 455 beziehungsweise auf einem der Pixel 459.

Daher können bei diesem Ausführungsbeispiel Messungen mit beiden Wellenlängenbereichen gleichzeitig durchgeführt werden. Dieser Ansatz ist folglich besonders gut für den Fall geeignet, dass der eigentliche zu messenden Abstand zwischen den beiden Grenzflächen ungünstig zwischen den Wellenlängenbereichen liegt und idealerweise die Messung mit beiden Wellenlängenbereichen gleichzeitig durchgeführt werden soll.

Um das Licht 460, 462 aus unterschiedlichen Richtungen auf das dispersive optische Element 449 richten zu können, kann bei faserbasierten Anordnungen das Licht der jeweiligen Wellenlänge über eigene Fasern geführt werden. In der Objektebene der Spektrometeroptik sind dann die beiden Enden der Fasern nebeneinander anzuordnen. Bei dem in der Figur 7 gezeigten Ausführungsbeispiel wäre ein Versatz der Faserenden entlang der x-Richtung für die Ansteuerung der beiden Detektorzeilen 453, 455 und ein Versatz in der y-Richtung für die Angleichung des dispersiven Effekts des Gitters 449 für die verschiedenen Wellenlängenbereiche vorzusehen. Generell kann bei einer Anordnung mit Freistrahlausbreitung die Anpassung der Strahlausbreitung beispielsweise über eine Ausrichtung von Blenden oder durch die Verwendung von Keilprismen erzielt werden.

Ebenfalls generell lässt sich die gewünschte räumliche Trennung von Licht mit zwei verschiedenen Wellenlängenbereichen auf dem Detektor nicht nur durch unterschiedliche Einfallsrichtungen des jeweiligen Lichts auf das dispersive optische Element sicherstellen. Alternativ hierzu kommt beispielsweise in Betracht, das Licht unterschiedlich zu polarisieren, z.B. orthogonal linear polarisiert oder entgegengesetzt zirkular polarisiert. Dann lässt sich mit Hilfe von geeigneten Polarisationsfiltern, die beispielsweise unmittelbar vor oder auf den Pixeln 457, 459 angeordnet sind, erreichen, dass das Licht mit der einen Wellenlänge nur auf Pixel fällt, auf die kein Licht mit der anderen Wellenlänge fallen kann, und umgekehrt.

Werden bei einer Messung zwei Spektren für einen Dickenwert erzeugt, kann der Dickenwert aus den beiden Teilspektren errechnet werden. Werden zwei Messspektren mit unterschiedlicher Bandbreite eingesetzt, liefert das schmalbandigere Spektrum für dickere Wafer eine höhere Genauigkeit, das breitbandigere Spektrum für dünne Wafer.

Die Berechnung des Dickenwertes kann beispielsweise eine statistische Gewichtung der beiden Teilspektren vorsehen. Das schmalbandigere Spektrum liefert für dicke Wafer eine höhere Genauigkeit, das breitbandige Spektrum für dünne Wafer. Der errechenbare Dickenwert wird jeweils auf Basis desjenigen Teilspektrums vorgenommen, das sich für die aktuelle Dicke am besten eignet.

Bevorzugt wird bei dieser Berechnung kein fester Schwellenwert, sondern eine Verrechnung beispielsweise anhand eines gewichteten Mittelwerts vorgenommen. Dabei kann ein Übergangsbereich festgelegt sein, innerhalb dessen die Gewichtung davon abhängt, an welcher Stelle des Übergangsbereichs sich die momentan zu messende Dicke ungefähr befindet oder/und die Gewichtung kann vom letzten berechneten Wert oder/und von den beiden gemessenen Werten abhängig sein.

Alternativ oder zusätzlich kann die Gewichtung der beiden Messwerte für die gleiche Dicke auch anhand der Qualität der einzelnen ermittelten Messwerte vorgenommen werden. Als Maß der Qualität kann eine Höhe des Messpeaks (entspricht der Amplitude der Interferenzmodulation) oder ein beliebiges Maß für das statistische Rauschen des Wertes (bspw. Variation über eine Zeitspanne) verwendet werden.

### Fünftes Ausführungsbeispiel

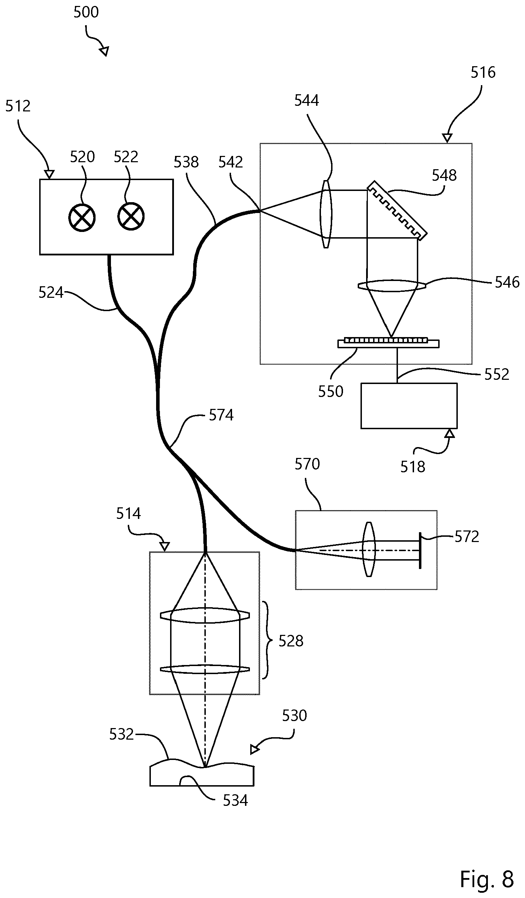

Um nicht nur - wie in den vorherigen Ausführungsformen - den Abstand zweier Grenzflächen bestimmen zu können, sondern auch absolute Entfernungsmesswerte zu erhalten, kann ein Referenzlicht bereitgestellt werden. Die Figur 8 zeigt ein Ausführungsbeispiel für eine solche Messvorrichtung 500. Diese entspricht weitgehend dem in der Figur 6 gezeigten Ausführungsbeispiel mit dem Unterschied, dass zusätzlich ein Referenzarm 570 mit einem endseitigen Spiegel 572 an einen Faserkoppler 574 angeschlossen ist. Zusätzlich ist aus Gründen der Übersichtlichkeit nur ein einziger Lichtweg für eine Lichtwellenlänge gezeigt. In dem Referenzarm 570 wird von der Lichtquelle 512 erzeugtes Messlicht an dem Spiegel 572 reflektiert und interferiert in einem Faserkoppler 574 mit an einem der Oberflächen 532, 534 des Messobjekts 530 reflektierten Messlicht. Die Interferenz wird von dem Spektrometer 516 erfasst und erzeugt auf dem Detektor 550 ein moduliertes Spektrum. Durch eine schnelle Fourier-Transformation (FFT, *Fast Fourier Transformation)* können aus dem Spektrum Modulationsfrequenzen gewonnen werden, die jeweils einem Abstandswert zugeordnet sind. Wegen weiterer Einzelheiten wird auf die DE 10 2016 005 021 A1 der Anmelderin verwiesen.

Um die FFT durchführen zu können, muss zunächst aus den von den einzelnen Pixeln pᵢ gemessen Intensitätswerten *P*ᵢₙₜ(pᵢ) die phasenabhängige Intensität *P*ᵢₙₜ(*kᵢ*) abgeleitet werden. Die Wellenzahl k ist dabei durch die Beziehung$k = n \left(λ\right) / λ$ mit der Wellenlänge λ verknüpft, wobei n(λ) die Dispersion des Mediums bezeichnet, aus dem das Messobjekt 530 besteht und in welches das Messlicht gegebenenfalls eindringt. Die Wellenlänge λ ist wiederum über eine Zuordnungstabelle pᵢ = pᵢ (λᵢ) den Pixelnummern p zugeordnet. Das Ergebnis ist eine Zuordnung zwischen Wellenzahlen k und Pixelnummern p, die für die Umrechnung der pixelabhängigen Intensität *P*ᵢₙₜ(pᵢ) auf die phasenabhängige Intensität *P*ᵢₙₜ(kᵢ) benötigt wird. Für weitere Einzelheiten hierzu wird auf die DE 10 2017 122 689 A1 der Anmelderin verwiesen. Anwendungsabhängig können mehrere Referenzarme und/oder ein längenverstellbarer Referenzarm eingesetzt werden.

### Sechstes Ausführungsbeispiel

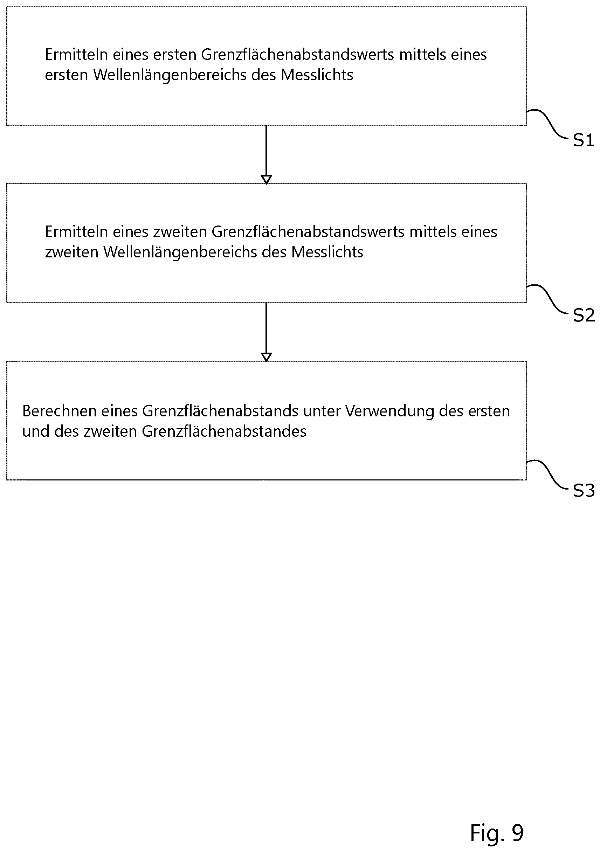

In Figur 9 ist eine Ausführungsform des erfindungsgemäßen Verfahrens veranschaulicht. In einem ersten (S1) und einem zweiten (S2) Schritt werden ein erster Grenzflächenabstandswert (Wert des Abstands zwischen einer ersten und einer zweiten Grenzfläche) mittels eines ersten Wellenlängenbereichs des Messlichts und ein zweiter Grenzflächenabstandswert mittels eines zweiten Wellenlängenbereichs des Messlichts ermittelt. Dafür kann beispielsweise ein Messlicht in einem ersten und einem zweiten Wellenlängenbereich erzeugt werden. Hierfür kann wie bereits vorstehend beschrieben der erste Wellenlängenbereich im Sichtbaren, beispielsweise zwischen 430 nm und 700 nm liegen. Der zweite Wellenlängenbereich kann beispielsweise ein Teilbereich im Bereich 700 nm bis 1600 nm sein, insbesondere ca. 830 nm bis ca. 930 nm, ca. 870 nm bis ca. 970 nm oder ca. 950 nm bis ca. 1100 nm. Bevorzugt unterscheidet sich die Bandbreite der ersten Lichtquelle von der Bandbreite der zweiten Lichtquelle. Insbesondere ist der erste Wellenlängenbereich breitbandig und der zweite Wellenlängenbereich vergleichsweise schmaler. Der schmalbandigere Wellenlängenbereich liefert für dicke Wafer eine höhere Genauigkeit, der breitbandige Wellenlängenbereich für dünne Wafer. Bei einer bevorzugten Ausführungsform ist die erste Lichtquelleneinheit eine Leuchtdiode (LED) und die zweite Lichtquelleneinheit eine Superlumineszenzdiode (SLD). Besonders bevorzugt ist der schmalbandigere Wellenlängenbereich für den langwelligen Wellenlängenbereich und der breitbandige Wellenlängenbereich für den kurzwelligen Wellenlängenbereich.

Bei der Ermittlung der Grenzflächenabstandswerte kann das Messlicht schnell zwischen den beiden Wellenlängenbereichen umgeschaltet werden, beispielsweise mit einer Frequenz im kHz-Bereich, also etwa zwischen 0,5 kHz und 100 kHz. Auf diese Weise besteht die Möglichkeit, einen nahezu kontinuierlichen Übergang zwischen den einzelnen Wellenlängen- und damit auch Messbereichen zu erzielen. Gleichzeitig kann in einem Messbereich, der zwar von zwei Wellenlängenbereichen abgedeckt wird, in dem aber das jeweilige einzelne Messlicht nur eine schlechtere Qualität/Intensität bietet, durch Mittelung der beiden Messlichtergebnisse ein insgesamt deutlich besseres Messsignal erzielt werden.

Dazu kann beispielsweise eine gewichtete Mittelung, beispielsweise gewichtet anhand der Qualität des Messsignals, erfolgen (S3).

## Patentansprüche

1. Optische Dickenmessvorrichtung (100) mit einer Lichtquelle (112), einem Messkopf (114), einem optischen Spektrometer (116) mit einer optischen Komponente (148) zur spektralen Aufspaltung eines Eingangslichts und einem Detektor (150), sowie einer Auswerteeinrichtung (118), wobei
a) die Lichtquelle (112) mit dem Messkopf (114) optisch verbunden und dazu eingerichtet ist, ein Messlicht zu erzeugen und an den Messkopf (114) zu leiten,
b) der Messkopf (114) mit dem Spektrometer (116) optisch verbunden und dazu eingerichtet ist,
- das Messlicht auf ein Messobjekt (130) zu leiten und davon reflektiertes Licht, das von zwei unterschiedlichen Grenzflächen (132, 134) stammt, aufzufangen und
- das Reflexionslicht als Eingangslicht an das Spektrometer (116) zu leiten,
c) das Spektrometer (116) mit der Auswerteeinrichtung (118) elektrisch verbunden und dazu eingerichtet ist, ein Spektrum des Reflexionslichts, das von den zwei unterschiedlichen Grenzflächen des Messobjekts (130) stammt und miteinander interferiert, zu erzeugen und das Spektrum als elektrisches Signal an die Auswerteeinrichtung (118) zu senden,
d) die Auswerteeinrichtung (118) dazu eingerichtet ist, auf Basis der elektrischen Signale einen Abstand zwischen den zwei Grenzflächen (132, 134) zu bestimmen,
e) das Messlicht mindestens einen ersten und einen zweiten unterschiedlichen Wellenlängenbereich aufweist, und
f) das Spektrometer zwei Lichteingänge (140, 142, 240, 242, 340, 342) für das Reflexionslicht aufweist, wobei aus dem ersten Lichteingang (140, 240, 340) Reflexionslicht des ersten Wellenlängenbereichs tritt und aus dem zweiten Lichteingang (142, 242, 342) Reflexionslicht des zweiten Wellenlängenbereichs tritt,
**dadurch gekennzeichnet, dass**
g) die Lichteingänge (140, 142, 240, 242, 340, 342) derart räumlich beabstandet sind, dass beide Wellenlängenbereiche durch die gemeinsame optische Komponente (148) spektral aufgespalten werden und die Abbildungsbereiche auf dem Detektor (150) sich in Richtung der spektralen Aufspaltung zumindest teilweise überlappen.

2. Vorrichtung nach Anspruch 1, wobei die Lichtquelle (112) eine erste Lichtquelleneinheit (120) und eine zweite Lichtquelleneinheit (122) umfasst.

3. Vorrichtung nach Anspruch 2, wobei sich die Bandbreite der ersten Lichtquelleneinheit (120) von der Bandbreite der zweiten Lichtquelleneinheit (122) unterscheidet.

4. Vorrichtung nach Anspruch 2 und/oder 3, wobei die erste Lichtquelleneinheit (120) unabhängig von der zweiten Lichtquelleneinheit (122) schaltbar ist.

5. Vorrichtung nach einem der vorhergehenden Ansprüche, wobei die Lichtquelle (112) so eingerichtet ist, dass das Messlicht im ersten Wellenlängenbereich abwechselnd mit dem Messlicht im zweiten Wellenlängenbereich, vorzugsweise in einem festen Takt, erzeugbar ist.

6. Vorrichtung nach Anspruch 5, wobei das Spektrum von der Auswerteeinrichtung (118) synchron mit dem Takt der Lichtquellenschaltung ausgelesen wird.

7. Vorrichtung nach einem der vorhergehenden Ansprüche, wobei der Detektor (451 zwei Zeilen (453, 455) umfasst, die getrennt auslesbar sind.

8. Vorrichtung nach Anspruch 7, wobei die Zeilen in der Raumrichtung quer zur spektralen Aufspaltung verschoben, bevorzugt direkt übereinander, liegen.

9. Vorrichtung nach einem der vorhergehenden Ansprüche, mit einem Referenzarm (570).

10. Vorrichtung nach einem der vorhergehenden Ansprüche, wobei die Verbindungen zwischen Lichtquelle (112) und Messkopf (114) und/oder zwischen Messkopf (114) und Spektrometer (116) jeweils zwei Lichtwellenleiter (124, 126, 136, 138) umfassen.

11. Vorrichtung nach einem der vorhergehenden Ansprüche, wobei die Auswertevorrichtung (118) dazu eingerichtet ist, mit jeweils dem Messlicht des ersten und des zweiten Wellenlängenbereichs ein erstes und ein zweites Spektrum des ersten bzw. zweiten Reflexionslichts zu erzeugen, aus den jeweiligen Spektren die jeweilige Dicke zu bestimmen und die beiden Werte für die Dicke miteinander zu verrechnen.

12. Optische Dickenmessvorrichtung (100) mit einer Lichtquelle (112), einem Messkopf (114), einem optischen Spektrometer (116) mit einer optischen Komponente (148) zur spektralen Aufspaltung eines Eingangslichts und einem Detektor (150), sowie einer Auswerteeinrichtung (118), wobei
a) die Lichtquelle (112) mit dem Messkopf (114) optisch verbunden und dazu eingerichtet ist, ein Messlicht zu erzeugen und an den Messkopf (114) zu leiten,
b) der Messkopf (114) mit dem Spektrometer (116) optisch verbunden und dazu eingerichtet ist, das Messlicht auf ein Messobjekt (130) zu leiten und davon reflektiertes Licht, das von zwei unterschiedlichen Grenzflächen (132, 134) stammt, aufzufangen und das Reflexionslicht als Eingangslicht an das Spektrometer (116) zu leiten,
c) das Spektrometer (116) mit der Auswerteeinrichtung (118) elektrisch verbunden und dazu eingerichtet ist, ein Spektrum des Reflexionslichts, das von den zwei unterschiedlichen Grenzflächen (132, 134) des Messobjekts (130) stammt und miteinander interferiert, zu erzeugen und das Spektrum als elektrisches Signal an die Auswerteeinrichtung (118) zu senden,
d) die Auswerteeinrichtung (118) dazu eingerichtet ist, einen Abstand zwischen den zwei Grenzflächen (132, 134) zu bestimmen,
e) das Messlicht mindestens einen ersten und einen zweiten unterschiedlichen Wellenlängenbereich aufweist,
**dadurch gekennzeichnet, dass**
f) das Eingangslicht des Spektrometers in den beiden Wellenlängenbereichen durch die gemeinsame optische Komponente (148) spektral aufgespaltet wird, wobei
g) die Lichtquelle (112) so eingerichtet ist, dass das Messlicht im ersten Wellenlängenbereich, vorzugsweise in einem festen Takt, abwechselnd mit dem Messlicht im zweiten Wellenlängenbereich erzeugbar ist, und wobei
h) das Spektrum von der Auswerteeinrichtung (118) synchron mit dem Takt der Lichtquellenschaltung ausgelesen wird.

13. Vorrichtung nach Anspruch 12, wobei jeweils nur Bereiche des Detektors (150) ausgelesen werden, auf denen der Wellenlängenbereich abgebildet wird, der gleichzeitig zum Auslesen erzeugt wird.

14. Verfahren zur Ermittlung des Abstands zweier Grenzflächen eines Messobjekts anhand einer Vorrichtung nach einem der vorhergehenden Ansprüche, mit den Schritten:
a) Erzeugen eines zumindest niedrigkohärenten Messlichts mit einem ersten Wellenlängenbereich;
b) Leiten des Messlichts auf das Messobjekt;
c) Auffangen des reflektierten Lichts und Erzeugen eines Spektrums des Reflexionslichts, welches an verschiedenen Grenzflächen reflektiert wurde und miteinander interferiert;
d) Wiederholen der Schritte a)-c) mit Messlicht eines zweiten Wellenlängenbereichs;
e) Ermitteln eines ersten Grenzflächenabstandswerts mittels des ersten Wellenlängenbereichs des Messlichts;
f) Ermitteln eines zweiten Grenzflächenabstandswerts mittels des zweiten Wellenlängenbereichs des Messlichts;
g) Berechnen eines Grenzflächenabstands unter Verwendung des ersten und/oder des zweiten Grenzflächenabstandswertes.

15. Verfahren nach Anspruch 14, wobei die Interferenz des Reflexionslichts entweder zwischen einem Reflexionslicht einer Grenzfläche des Messobjekts und einem Referenzlicht oder/und zwischen einem Reflexionslicht einer ersten Grenzfläche des Messobjekts und dem Reflexionslicht einer zweiten Grenzfläche des Messobjekts erfolgt.

16. Verfahren nach einem der Ansprüche 14 oder 15, wobei bei der Berechnung des Grenzflächenabstands eine Mittelung des ersten und des zweiten Grenzflächenabstands, bevorzugt eine gewichtete Mittelung, erfolgt.

## Claims

1. Optical thickness measuring device (100) having a light source (112), a measuring head (114), an optical spectrometer (116) having an optical component (148) for spectral splitting of input light and a detector (150), and an evaluation device (118), wherein
a) the light source (112) is optically connected to the measuring head (114) and is configured to generate measurement light and to direct it to the measuring head (114),
b) the measuring head (114) is optically connected to the spectrometer (116) and is configured to
- direct the measurement light onto a measurement object (130) and to capture light reflected therefrom, which originates from two different interfaces (132, 134), and
- direct the reflected light as input light to the spectrometer (116),
c) the spectrometer (116) is electrically connected to the evaluation device (118) and is configured to generate a spectrum of the reflected light, which originates from the two different interfaces of the measurement object (130) and interferes with one another, and to send the spectrum as an electrical signal to the evaluation device (118),
d) the evaluation device (118) is configured to determine, on the basis of the electrical signals, a distance between the two interfaces (132, 134),
e) the measurement light comprises at least a first and a second different wavelength range, and
f) the spectrometer has two light inputs (140, 142, 240, 242, 340, 342) for the reflected light, wherein reflected light of the first wavelength range exits from the first light input (140, 240, 340) and reflected light of the second wavelength range exits from the second light input (142, 242, 342),
**characterized in that**
g) the light inputs (140, 142, 240, 242, 340, 342) are spatially spaced apart such that both wavelength ranges are spectrally split by the common optical component (148) and the imaging regions on the detector (150) at least partially overlap in the direction of the spectral splitting.

2. Device according to claim 1, wherein the light source (112) comprises a first light source unit (120) and a second light source unit (122).

3. Device according to claim 2, wherein the bandwidth of the first light source unit (120) differs from the bandwidth of the second light source unit (122).

4. Device according to claim 2 and/or 3, wherein the first light source unit (120) is switchable independently of the second light source unit (122).

5. Device according to any one of the preceding claims, wherein the light source (112) is configured such that the measurement light in the first wavelength range can be generated alternately with the measurement light in the second wavelength range, preferably in a fixed cycle.

6. Device according to claim 5, wherein the spectrum is read out by the evaluation device (118) synchronously with the cycle of the light source switching.

7. Device according to any one of the preceding claims, wherein the detector (451) comprises two lines (453, 455) which can be read out separately.

8. Device according to claim 7, wherein the lines are offset, preferably directly one above the other, in the spatial direction transverse to the spectral splitting.

9. Device according to any one of the preceding claims, having a reference arm (570).

10. Device according to any one of the preceding claims, wherein the connections between the light source (112) and the measuring head (114) and/or between the measuring head (114) and the spectrometer (116) each comprise two optical waveguides (124, 126, 136, 138).

11. Device according to any one of the preceding claims, wherein the evaluation device (118) is configured to generate, using in each case the measurement light of the first and the second wavelength range, a first and a second spectrum of the first and second reflected light, respectively, to determine the respective thickness from the respective spectra, and to combine the two values for the thickness.

12. Optical thickness measuring device (100) having a light source (112), a measuring head (114), an optical spectrometer (116) having an optical component (148) for spectral splitting of input light and a detector (150), and an evaluation device (118), wherein
a) the light source (112) is optically connected to the measuring head (114) and is configured to generate measurement light and to direct it to the measuring head (114),
b) the measuring head (114) is optically connected to the spectrometer (116) and is configured to direct the measurement light onto a measurement object (130), to capture light reflected therefrom, which originates from two different interfaces (132, 134), and to direct the reflected light as input light to the spectrometer (116),
c) the spectrometer (116) is electrically connected to the evaluation device (118) and is configured to generate a spectrum of the reflected light, which originates from the two different interfaces (132, 134) of the measurement object (130) and interferes with one another, and to send the spectrum as an electrical signal to the evaluation device (118),
d) the evaluation device (118) is configured to determine a distance between the two interfaces (132, 134),
e) the measurement light comprises at least a first and a second different wavelength range,
**characterized in that**
f) the input light of the spectrometer in the two wavelength ranges is spectrally split by the common optical component (148), wherein
g) the light source (112) is configured such that the measurement light in the first wavelength range can be generated, preferably in a fixed cycle, alternately with the measurement light in the second wavelength range, and wherein
h) the spectrum is read out by the evaluation device (118) synchronously with the cycle of the light source switching.

13. Device according to claim 12, wherein in each case only regions of the detector (150) are read out onto which the wavelength range that is generated simultaneously with the reading-out is imaged.

14. Method for determining the distance between two interfaces of a measurement object using a device according to any one of the preceding claims, comprising the steps of:
a) generating measurement light having at least low coherence and having a first wavelength range;
b) directing the measurement light onto the measurement object;
c) capturing the reflected light and generating a spectrum of the reflected light, which was reflected at different interfaces and interferes with one another;
d) repeating steps a) to c) with measurement light of a second wavelength range;
e) determining a first interface distance value using the first wavelength range of the measurement light;
f) determining a second interface distance value using the second wavelength range of the measurement light;
g) calculating an interface distance using the first and/or the second interface distance value.

15. Method according to claim 14, wherein the interference of the reflected light takes place either between reflected light of one interface of the measurement object and reference light or/and between reflected light of a first interface of the measurement object and the reflected light of a second interface of the measurement object.

16. Method according to either claim 14 or claim 15, wherein, when calculating the interface distance, averaging of the first and the second interface distance is carried out, preferably weighted averaging.

## Revendications

1. Dispositif optique de mesure d'épaisseur (100) avec une source lumineuse (112), une tête de mesure (114), un spectromètre optique (116) avec un composant optique (148) pour la décomposition spectrale d'une lumière d'entrée et un détecteur (150), ainsi qu'une unité d'évaluation (118), dans lequel
a) la source lumineuse (112) est reliée optiquement à la tête de mesure (114) et est conçue pour générer une lumière de mesure et l'acheminer vers la tête de mesure (114),
b) la tête de mesure (114) est reliée optiquement au spectromètre (116) et est conçue pour
- diriger la lumière de mesure sur un objet de mesure (130) et recueillir de la lumière réfléchie provenant de deux interfaces différentes (132, 134) et
- acheminer la lumière de réflexion en tant que lumière d'entrée vers le spectromètre (116),
c) le spectromètre (116) est relié électriquement à l'unité d'évaluation (118) et est conçu pour générer un spectre de la lumière de réflexion qui provient des deux interfaces différentes de l'objet de mesure (130) et interfère mutuellement, et pour envoyer le spectre en tant que signal électrique à l'unité d'évaluation (118),
d) l'unité d'évaluation (118) est conçue pour déterminer, sur la base des signaux électriques, une distance entre les deux interfaces (132, 134),
e) la lumière de mesure présente au moins une première et une deuxième plage de longueurs d'onde différentes, et
f) le spectromètre présente deux entrées de lumière (140, 142, 240, 242, 340, 342) pour la lumière de réflexion, de la lumière de réflexion de la première plage de longueurs d'onde sortant de la première entrée de lumière (140, 240, 340) et de la lumière de réflexion de la deuxième plage de longueurs d'onde sortant de la deuxième entrée de lumière (142, 242, 342),
**caractérisé en ce que**
g) les entrées de lumière (140, 142, 240, 242, 340, 342) sont espacées spatialement de telle manière que les deux plages de longueurs d'onde sont décomposées spectralement par le composant optique commun (148) et que les zones de formation d'image sur le détecteur (150) se chevauchent au moins partiellement dans la direction de la décomposition spectrale.

2. Dispositif selon la revendication 1, dans lequel la source lumineuse (112) comprend une première unité de source lumineuse (120) et une deuxième unité de source lumineuse (122).

3. Dispositif selon la revendication 2, dans lequel la largeur de bande de la première unité de source lumineuse (120) diffère de la largeur de bande de la deuxième unité de source lumineuse (122).

4. Dispositif selon la revendication 2 et/ou 3, dans lequel la première unité de source lumineuse (120) peut être commutée indépendamment de la deuxième unité de source lumineuse (122).

5. Dispositif selon l'une des revendications précédentes, dans lequel la source lumineuse (112) est conçue de telle manière que la lumière de mesure dans la première plage de longueurs d'onde peut être générée en alternance avec la lumière de mesure dans la deuxième plage de longueurs d'onde, de préférence selon une cadence fixe.

6. Dispositif selon la revendication 5, dans lequel le spectre est lu par l'unité d'évaluation (118) de manière synchrone avec la cadence de commutation de la source lumineuse.

7. Dispositif selon l'une des revendications précédentes, dans lequel le détecteur (451 comprend deux rangées (453, 455), qui peuvent être lues séparément.

8. Dispositif selon la revendication 7, dans lequel les rangées sont disposées décalées dans la direction spatiale transversale à la décomposition spectrale, de préférence directement l'une au-dessus de l'autre.

9. Dispositif selon l'une des revendications précédentes, avec un bras de référence (570).

10. Dispositif selon l'une des revendications précédentes, dans lequel les liaisons entre la source lumineuse (112) et la tête de mesure (114) et/ou entre la tête de mesure (114) et le spectromètre (116) comprennent chacune deux guides d'ondes optiques (124, 126, 136, 138).

11. Dispositif selon l'une des revendications précédentes, dans lequel le dispositif d'évaluation (118) est conçu pour générer, avec respectivement la lumière de mesure de la première et de la deuxième plage de longueurs d'onde, un premier et un deuxième spectre de la première, respectivement de la deuxième lumière de réflexion, pour déterminer l'épaisseur respective à partir des spectres respectifs et pour combiner par calcul les deux valeurs de l'épaisseur.

12. Dispositif optique de mesure d'épaisseur (100) avec une source lumineuse (112), une tête de mesure (114), un spectromètre optique (116) avec un composant optique (148) pour la décomposition spectrale d'une lumière d'entrée et un détecteur (150), ainsi qu'une unité d'évaluation (118), dans lequel
a) la source lumineuse (112) est reliée optiquement à la tête de mesure (114) et est conçue pour générer une lumière de mesure et l'acheminer vers la tête de mesure (114),
b) la tête de mesure (114) est reliée optiquement au spectromètre (116) et est conçue pour diriger la lumière de mesure sur un objet de mesure (130) et recueillir de la lumière réfléchie provenant de deux interfaces différentes (132, 134) et acheminer la lumière de réflexion en tant que lumière d'entrée vers le spectromètre (116),
c) le spectromètre (116) est relié électriquement à l'unité d'évaluation (118) et est conçu pour générer un spectre de la lumière de réflexion qui provient des deux interfaces différentes (132, 134) de l'objet de mesure (130) et interfère mutuellement, et pour envoyer le spectre en tant que signal électrique à l'unité d'évaluation (118),
d) l'unité d'évaluation (118) est conçue pour déterminer une distance entre les deux interfaces (132, 134),
e) la lumière de mesure présente au moins une première et une deuxième plage de longueurs d'onde différentes,
**caractérisé en ce que**
f) la lumière d'entrée du spectromètre dans les deux plages de longueurs d'onde est décomposée spectralement par le composant optique commun (148), dans lequel
g) la source lumineuse (112) est conçue de telle manière que la lumière de mesure dans la première plage de longueurs d'onde, de préférence selon une cadence fixe, peut être générée en alternance avec la lumière de mesure dans la deuxième plage de longueurs d'onde, et dans lequel
h) le spectre est lu par l'unité d'évaluation (118) de manière synchrone avec la cadence de commutation de la source lumineuse.

13. Dispositif selon la revendication 12, dans lequel seules, à chaque fois, des zones du détecteur (150) sont lues sur lesquelles est imagée la plage de longueurs d'onde qui est générée simultanément à la lecture.

14. Procédé de détermination de la distance entre deux interfaces d'un objet de mesure à l'aide d'un dispositif selon l'une des revendications précédentes, comprenant les étapes suivantes :
a) génération d'une lumière de mesure au moins faiblement cohérente avec une première plage de longueurs d'onde ;
b) acheminement de la lumière de mesure sur l'objet de mesure ;
c) recueil de la lumière réfléchie et génération d'un spectre de la lumière de réflexion, laquelle a été réfléchie sur différentes interfaces et interfère mutuellement ;
d) répétition des étapes a)-c) avec une lumière de mesure d'une deuxième plage de longueurs d'onde ;
e) détermination d'une première valeur de distance entre interfaces au moyen de la première plage de longueurs d'onde de la lumière de mesure ;
f) détermination d'une deuxième valeur de distance entre interfaces au moyen de la deuxième plage de longueurs d'onde de la lumière de mesure ;
g) calcul d'une distance entre interfaces en utilisant la première et/ou la deuxième valeur de distance entre interfaces.

15. Procédé selon la revendication 14, dans lequel l'interférence de la lumière de réflexion a lieu soit entre une lumière de réflexion d'une interface de l'objet de mesure et une lumière de référence ou/et entre une lumière de réflexion d'une première interface de l'objet de mesure et la lumière de réflexion d'une deuxième interface de l'objet de mesure.

16. Procédé selon l'une des revendications 14 ou 15, dans lequel, lors du calcul de la distance entre interfaces, une moyenne de la première et de la deuxième distance entre interfaces, de préférence une moyenne pondérée, est effectuée.
